# EUROPEAN PATENT APPLICATION

(11) **EP 4 258 373 A1**
(43) Date of publication of application: **11.10.2023**
(21) Application number: 22167022.7
(22) Date of filing: 06.04.2022
(51) Int. Cl.: H01L 51/42, C01G 21/00

(54) **FUNCTIONAL HALIDE PEROVSKITE COMPOSITES**

(71) Applicant: KEP Innovation Center SA, 1228 Plan-les-Ouates (CH)
(72) Inventor: Mettan, Xavier, 1228 Plan-les-Ouates (CH); Kollár, Márton, 1228 Plan-les-Ouates (CH); Horváth, Endre, 1228 Plan-les-Ouates (CH)
(74) Representative: ABREMA

(57) **Abstract**

This invention relates to a composite comprising a matrix of metal halide perovskite single crystal and a scaffold comprising a plurality of wire-like elements having a diameter being in the range from 6 to 5000 µm.

## Description

### Technical Field

The present invention relates to a perovskite-based composite, to perovskite-based devices comprising such a composite, and to its use for improving the mechanical and/or thermal resistances of perovskite-based device.

### Prior Art and the Problem Underlying the Invention

While a metal halide perovskite crystal has the general formula AMX₃ (A: one or more monovalent organic and/or inorganic cations, M: divalent metal and X: halide anions), the most studied perovskite single crystals are hybrid organic-inorganic perovskite or metal halide perovskites with three-dimensional crystal structure. They are widely applied in optoelectronics including, e.g., solar cells, photodetectors, sensors, light-emitting diodes (LED), and electrodes.

Unlike leading semiconductors on the market (e.g. in silicon, CZT (Cadmium Zinc Telluride) and HPGe (High purity Germanium)), the manufacture of perovskite single crystals and their crystal growth process to obtain highly pure crystals are straightforward. Due to their physical-chemical properties (high carrier mobility, long carrier diffusion length, low trap-state densities), single crystals of metal halide perovskite show an excellent tolerance to internal defects. They represent a material of choice for semiconductors used as a light-harvesting active layer or charge conductor.

Semiconductors of metal halide perovskite are usually applied in the form of a thin film (up to 2 µm of thickness) on a substrate through different deposition methods and are sandwiched between tailored electrodes. In the case of a_metal halide perovskite single crystal, which is an above millimeter-sized macroscopic crystal, crystallogenesis is made by solution processes known in the art as solution temperature lowering method (STL) or solution temperature increasing method, also named inverse temperature crystallization method (ITC) or retrograde crystallization.

However, several hurdles hinder large-scale commercialization of perovskite-based devices. One of these concerns the long-term performance and stability of these devices with multilayer architecture. The reasons of this instability are multiple and include the degradation of the perovskite itself with the time due to the full illumination and temperature constraints, and the reaction of said perovskite material with the material of the charge (electron or hole) transporting layers, the additional interfacial layers and the electrode metal (Au, Ag, Al, Cu, e.g.). A further ground of the instability of multilayer perovskite-based devices is the corrosion of the electrodes.

Using carbon-based materials for making electrodes is one solution against the electrode corrosion, as these materials are not subject to photo- and electro corrosion. WO 2017/212397A1 teaches reducing the thickness of a photodetector by using a composite thin film comprising a perovskite single crystal and carbon nanotubes. An organic-inorganic perovskite single crystal is grown on a substrate (e.g., glass, Si, indium tin oxide glass, and fluorine doped tin oxide glass), on which carbon nanotubes are not oriented but randomly arranged. The resulting composite comprises carbon nanotubes with no specific spatial orientation, alignment or pattern, which are embedded in a microcrystalline film of ultrathin perovskite single crystal.

Recently, a stable and operational light-emitting electrochemical cell with a simple multilayer architecture has been achieved (Andricevic et al., 2019, ACS Photonics, vol. 6, pp. 967-975). This cell comprises a metal halide perovskite single crystal sandwiched between two contact electrodes, said electrodes bearing vertically aligned carbon nanotubes that are embedded in the single crystal. Before the crystallization step, the carbon nanotubes have been grown on the metal oxide support of the electrodes. This support, the conductive layer of the electrodes, is necessary for the growth of the nanotubes, in particular for the vertical growth and alignment of the nanotubes so as to form a three--dimensional electrode. The cell presents a composite perovskite/nanotube structure in the vicinity of the oxide supports and merely perovskite material in its central portion. However, the possibility of the orientation of the carbon nanotubes in the perovskite single crystal to manufacture a three-dimensional electrode is very limited, which also limits the architecture and the use of such electrodes. Further, a substrate is necessary to align vertically the carbon nanotubes. The presence of a substrate also limits the achievement of more complex configurations or pattern of the fiber-like electrodes array such as for the Frisch-grid for gamma solid state detector. Further a substrate of metal oxide is not appropriate for the stability of the composite. The substrate is included in the perovskite single crystal, with the perovskite single crystal grown over it. The support or substrate cannot be removed from the perovskite single crystal and may, therefore, hinder the functioning of the composite or the device comprising such a composite, in particular if its material reacts with the perovskite material.

Most of time, the achievement of further configurations requires the formation of the electrodes network after the fabrication of the crystal. Thus, in the case of a solids--state silicon radiation detector with detector electrodes in silicon single crystal or of a fuel cell with the anode of porous-polyimide graphite film, the silicon crystal and the graphite film are rendered porous by, e.g., ion etching or laser-drilling pore technique before filling said holes or pores with doped polycrystalline silicon or polyimide, respectively.

During the crystallization process of a perovskite single crystal, mechanical fractures can appear because of the low thermal conductivity and high thermal dilatation during and post-crystal growth, weakening the structural integrity of the perovskite crystal. Further the perovskite single crystal shows unsatisfying mechanical properties to stress constraints such as forces appearing during quick acceleration or deceleration, shear forces compressive forces or tensile forces.

The present invention addresses the problems depicted above, such as the problems of instability and crystal integrity due to the mechanical and thermal constraints and the limited possibilities of having more complex geometric patterns of the fibre electrodes in the perovskite single-crystal, other than planar or vertical.

The present invention also aims to solve the problem of the limited application of perovskite-based composite for devices with ultrathin film or layer architecture due to the impossibility of having a complex geometric orientation of the electrodes.

The present invention further aims at broadening the selection of materials used for the electrodes in composites to achieve other junctions not limited to a type I heterojunction.

The present invention also addresses the problem of the formation of micro-cracks and visible cracks during the post-growth shaping of the perovskite single crystal.

The present invention also addresses the problem of the localization of the fibre electrodes only at the surface of the perovskite single crystal, since carbon nanotubes have a very limited length.

### Summary of the Invention

To address the problems depicted above, the present invention proposes a composite, wherein a scaffold comprising a plurality of wire-like elements is embedded in the matrix of metal halide perovskite single crystal, and wherein the wire-like elements being of the micro- and macroscopic order are arranged to form a two- or three-dimensional framework, wherein the wire-like elements are oriented in a determined manner.

The inventors have found that the as-prepared scaffold of two (2D) or three (3D) dimensions comprising wire-like elements increases the resistance of the perovskite single crystal to the mechanical stresses and improves the structural integrity and mechanical properties of said single crystal. The scaffold of the wire-like elements reinforces the structure and the integrity of the composite in the manner of metal framework. The fractures can be bound to the embedded scaffold, thus enhancing control over the location and size of fractures. The embedded scaffold reduces the internal stress and strain and lowers the risk of crack formation.

As a fibre reinforcement, said scaffold can also prevent or reduce crack formation during the crystal post-growth shaping, namely the tailoring of the crystal or composite. Improved impact resistance during polishing and cutting reduces the tendency of visible and non-visible crack (micro-crack) formation, crack widths, or allows the control of the crack widths tightly. Further the mechanical properties of the composite can be tuned by the selection of the material of the wire-like elements as well as the geometrical design of the 2D or 3D scaffold. Thus, the improved mechanical property of the composite allows its application in a wider range of technical fields, such as, but not limited to, heat conductors for heat management, optical sensing/actuating elements as optical detector, as 2D or 3D electrodes including polarization vector for magnetic and electric polarization.

Due to the increased complexity of the geometric pattern of the wire-like elements, especially when the wire-like elements are micro- or macroscopic, the use of such a perovskite-based composite can be considered for the manufacture of three-dimensional devices and not be limited to use for ultrathin film device.

According to one aspect, the present invention provides a composite comprising a matrix of metal halide perovskite single crystal and a scaffold comprising a plurality of wire-like elements having a diameter being in the range from 6 to 5000 µm

In a second aspect, the present invention relates to a perovskite-based device comprising a composite of the invention and being selected from an optoelectronic device, a photoelectrochemical device, or a two- or three-dimensional electrodes array.

A third aspect of the present invention concerns a use of the composite for improving the mechanical and/or thermal resistance of a perovskite-based device.

Further aspects and embodiments of the invention are detailed herein below and in the appended claims. Further features and advantages of the invention will become apparent to the skilled person from the description of the preferred embodiments given below.

### Brief Description of the Drawings

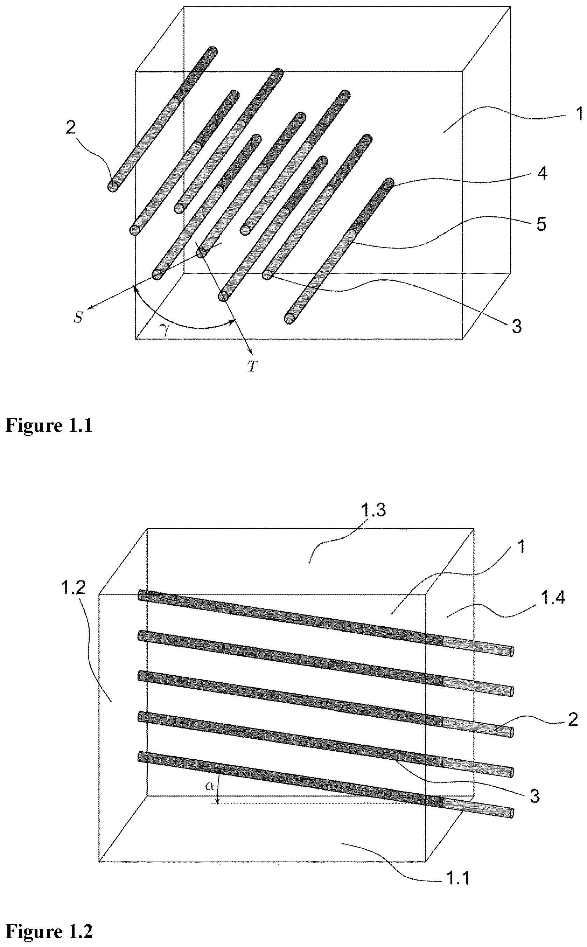

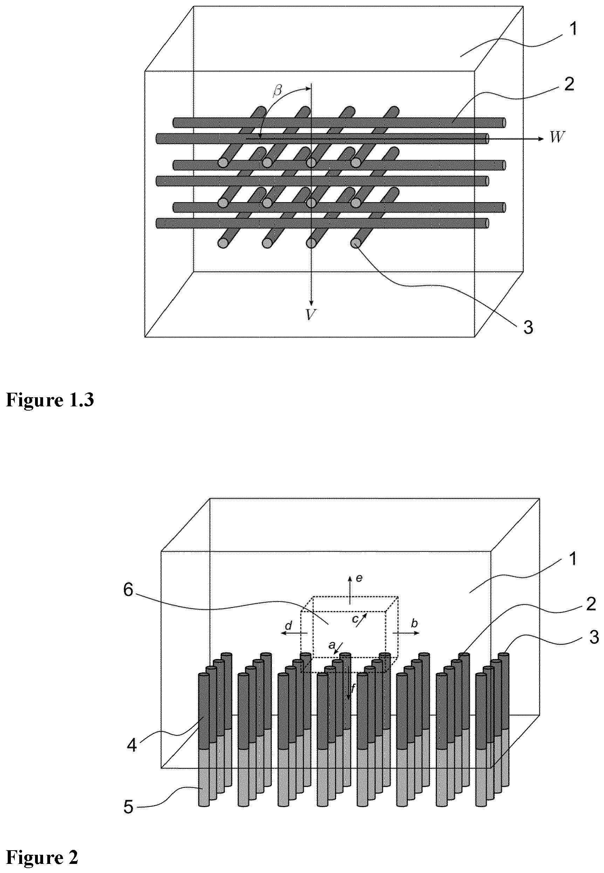

**Figure 1.1** is a schema of a three-dimensional view of a composite comprising a matrix of perovskite single crystal 1 and a scaffold of wire-like elements 2, 3. Part 4 of the wire-like element is embedded in the crystal and another part 5 is outside the crystal. **Figure 1****.****2** is a schema of a three-dimensional view of a composite comprising a matrix of perovskite single crystal 1 with the crystal facets 1.1, 1.2, 1.3, 1.4 and a scaffold of wire-like elements 2, 3 parallel to each other, said view being along the line of wire-like elements. **Figure 1****.****3** is a schema of a three-dimensionnal view of a composite comprising a matrix of perovskite single crystal 1 and a three-dimensional scaffold of wire-like elements 2, 3, wherein at least one end of said wire-like elements is not covered by the metal halide perovskite matrix.
**Figure 2** is a schema of the crystallogenesis of a matrix of perovskite single crystal 1 from a perovskite crystallite 6. The perovskite crystallite 6 on the top of the scaffold is used as a seed for the formation of the perovskite single crystal. Upon the crystallogenesis, the volume of the seed will increase in the six spatial directions a,b,c,d,e,f and the perovskite crystal will gradually grow around the wire-like elements 2, 3, part 4 of which will be embedded in the growing crystal and another part 5 will be remain outside the growing crystal, to form the perovskite-based matrix of the composite. The reaction vessel is not drawn.

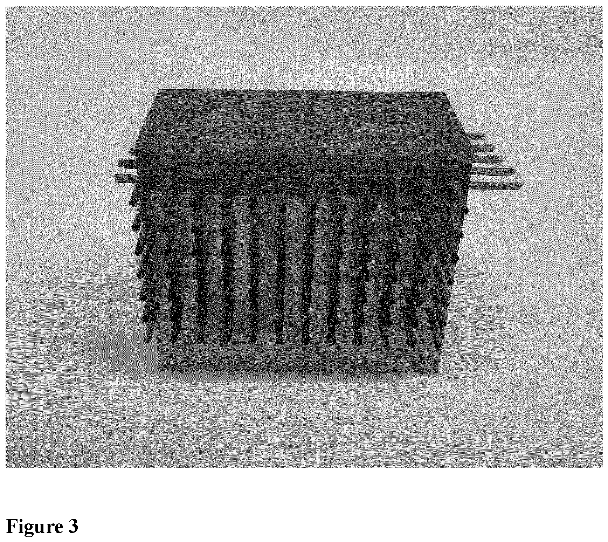

**Figure 3** is a picture of a composite comprising a three-dimensional scaffold of wire-like elements embedded in a CH₃NH₃PbBr₃ (MAPbBr₃) perovskite single crystal (scale bar :10 mm). The wire-like elements are carbon wires of 0.6 mm diameter and form a three-dimensional framework comprising a first set of first parallel carbon wires and a second set of second parallel carbon wires, the first set crossing the second set at right angle.

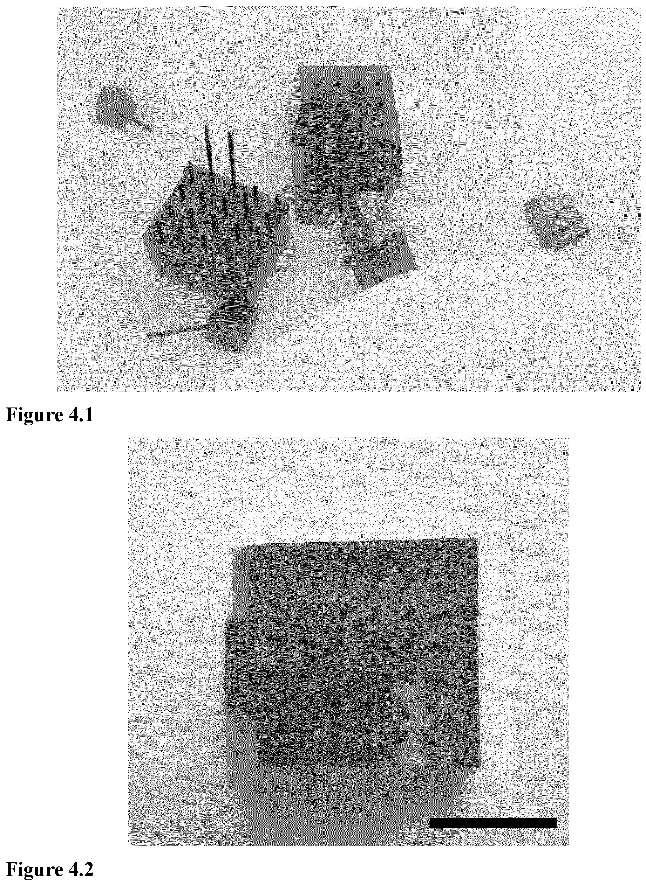

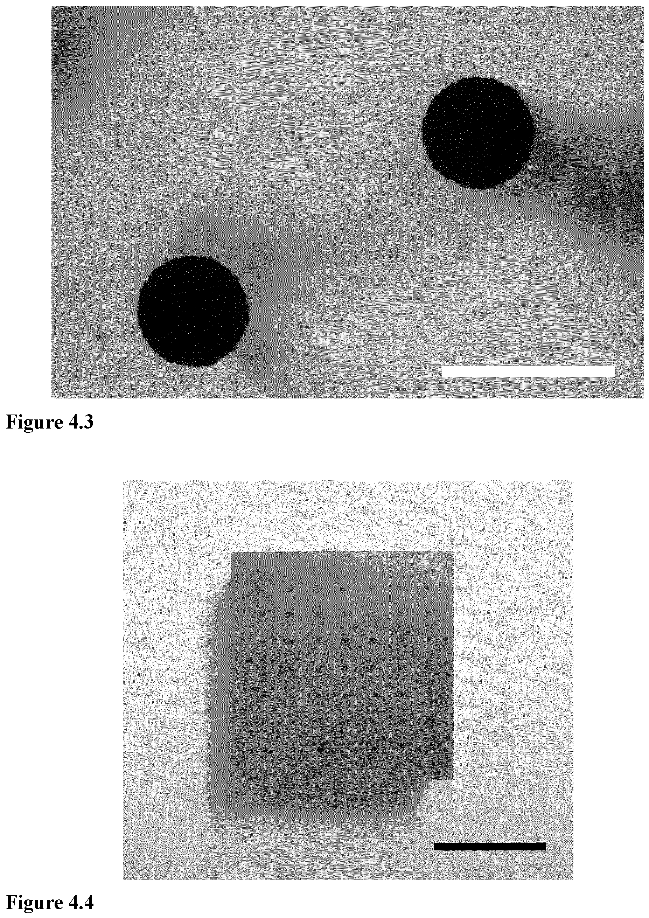

**Figure 4****.****1** is a picture of a composite comprising a MAPbBr₃ single crystal with carbon wire-like elements of 0.6 mm diameter, around which the MAPbBr₃ single crystal has grown in-situ. **Figure 4****.****2** is a picture of a composite comprising a MAPbBr₃ single crystal with carbon wire-like elements of 0.2 mm diameter and protruding out of the single crystal (scale bar: 10 mm). **Figure 4****.****3** is an enlarged picture of a composite similar to the composite of Figure 4.1 with two of the carbon wire-like elements of 0.6 mm diameter, and wherein one facet of the perovskite single crystal is polished (scale bar: 1 mm) . **Figure 4.4** is a picture of a facet of a composite similar to the composite of Figure 4.2, wherein the carbon wire-like elements of 0.2 mm diameter have been cut at the surface of the facet and polished together with the facet of the perovskite single crystal (scale bar: 10 mm). No polycrystallinity induced by the growth of the perovskite single crystal around the carbon wire-like elements is visible.

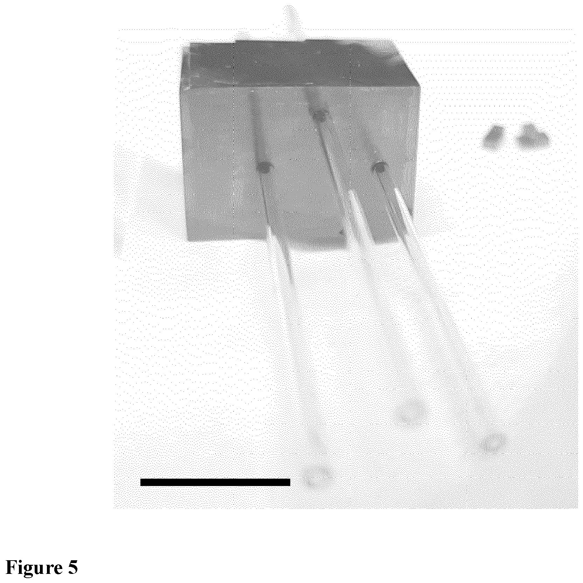

**Figure 5** is a picture of a composite comprising a first set of first glass hollow wire-like elements or capillaries being parallelly aligned in the matrix of a MAPbBr₃ single crystal (scale bar: 10 mm).

### Detailed Description of the invention

In the following, embodiments of the invention shall be described in detail with reference to the above-mentioned figures.

In one aspect, the invention concerns a composite comprising a matrix of metal halide perovskite single crystal and a scaffold comprising a plurality of wire-like elements having a diameter being in the range from 6 to 5·10³ µm.

According to an embodiment, the matrix of metal halide perovskite single crystal in the composite according to the invention comprises one metal halide perovskite single crystal.

According to another embodiment, the matrix of metal halide perovskite crystal in the composite according to the invention comprises more than one metal halide perovskite single crystal.

According to an embodiment, the scaffold in the composite is a two-dimensional framework of wire-like elements.

According to an embodiment, the scaffold in the composite is a two-dimensional framework comprising or consisting of a first set of first wire-like elements, wherein said first wire-like elements are parallel the ones to the others and contained in a same plane, thus forming an alignment of parallel wires.

A composite comprising a scaffold of the present embodiment consisting of one set of parallel wire-like elements 2 and a matrix of metal halide perovskite single crystal 1 is illustrated in Figure 1.2. The one set of parallel wire-like elements 2 of the scaffold is so-arranged that it forms an angle α between the axis of the one set of parallel wire-like elements and the facet 1.1 of the metal halide perovskite single crystal 1, said angle α being of between 0.0 and 90.0 degrees. The one set of parallel wire-like elements 2 may be horizontally arranged and forms an angle α of 0.0 degree, vertically arranged and forms an angle α of 90.0 degrees, or obliquely arranged and forms an angle α of between 0.1 and 89.9 degrees. In particular, the one set of parallel wire-like elements 2 may form an angle α with the facet 1.1 of the perovskite single crystal of between 0.0 and 45 degrees.

According to another embodiment, the scaffold in the composite is a two-dimensional framework comprising furthermore a second set of second wire-like elements, wherein said second wire-like elements are parallel the ones to the others and contained in the same plane or substantially in the same plane as the first set, and wherein said second wire-elements are not parallel to said first wire-like elements. Thus, said framework comprises an arrangement of interlocking wire-like elements similar to a grid or a mesh, wherein the wire-like elements are well-oriented and not only aligned or juxtaposed. The interlocking of the wire-like elements is sufficient to maintain the arrangement of said elements in a scaffold without the need of a substrate or support maintaining the arrangement, the pattern or the spatial configuration of the elements. Thus it is no longer necessary to use a mold or support, on which the filiform elements have to be grown or provided to stabilize them in a 2D or 3D dimension or a specific spatial configuration before and/or during crystallogenesis of the perovskite single crystal. However, the interlocking of the wire-like elements does not preclude maintaining the scaffold before and/or during crystallogenesis of the perovskite single crystal by holding means for handling the scaffold and thus the composite during its manufacture.

According to a further embodiment, the scaffold in the composite is a two-dimensional framework comprising furthermore a second set of second wire-like elements, wherein said second wire-like elements are parallel the ones to the others and contained in the same plane or substantially in the same plane as the first set, and wherein said second wire-elements are perpendicular to said first wire-like elements.

According to a further embodiment, the scaffold in the composite is a two-dimensional framework comprising furthermore a second set of second wire-like elements, wherein said second wire-like elements are parallel the ones to the others and contained in the same plane or substantially in the same plane as the first set, and wherein said second wire-like elements are arranged obliquely to said first wire-like elements and form an angle of between 0.1 and 89.9 degrees with said first wire-like elements.

According to another embodiment, the scaffold in the composite is a three-dimensional framework of wire-like elements.

According to another embodiment, the scaffold in the composite is a three-dimensional framework comprising a first set of first wire-like elements, wherein said first wire-like elements are parallel the ones to the others and are contained in a same plane or substantially in a same plane, and a second set of second wire-like elements, wherein said second wire-like elements are parallel the ones to the others and contained in a different plane than the first set. The second wire-elements are parallel or not to the first wire-like elements.

In another embodiment, the scaffold in the composite is a three-dimensional framework comprising a first set of first wire-like elements, wherein said first wire-like elements are parallel the ones to the others and are contained in a same plane or substantially in a same plane, and a second set of second wire-like elements, wherein said second wire-like elements are parallel the ones to the others and contained in a different plane than the first set, and wherein the second wire-elements are not parallel to said first wire-like elements. Thus said framework comprises a three-dimensional complex arrangement of wire-like elements, wherein all the wire-like elements are precisely oriented and not only aligned or juxtaposed.

In a further embodiement, the scaffold in the composite illustrated in Figure 1.1 is a three-dimensional framework comprising a first set of first wire-like elements 2, wherein said first wire-like elements 2 are parallel the ones to the others and are contained in a same plane or substantially in a same plane, and a second set of second wire-like elements 3, wherein said second wire-like elements 3 are parallel the ones to the others and contained in a different plane than the first set and wherein axis S and axis T of the three-dimensional framework form an angle γ of between 10 and 170 degrees, preferably between 50 and 130 degrees.

In another embodiment as illustrated in Figure 1.3, the scaffold in the composite is a three-dimensional framework consisting of a first set of first wire-like elements 2, wherein said first wire-like elements 2 are parallel the ones to the others and are contained in a same plane or substantially in a same plane, and a second set of second wire-like elements 3, wherein said second wire-like elements 3 are parallel the ones to the others and contained in a different plane than the first set, and wherein second wire-like elements are not parallel to said first wire-like elements and wherein axis V and axis W of the three-dimensional framework form an angle β of between 4 and 170 degrees, preferably between 55 and 125 degrees.

According to a further embodiment, the scaffold in the composite is a three-dimensional framework comprising a first set of first wire-like elements, wherein said first wire-like elements are parallel the ones to the others and are contained in a same plane or substantially in a same plane, and a second set of second wire-like elements, wherein said second wire-like elements are parallel the ones to the others and contained in a different plane than the first set, and wherein second wire-elements are perpendicular to said first wire-like elements.

According to a further embodiment, the scaffold in the composite is a three-dimensional framework comprising a first set of first wire-like elements, wherein said first wire-like elements are parallel the ones to the others and are contained in a same plane or substantially in a same plane, and a second set of second wire-like elements, wherein said second wire-like elements are parallel the ones to the others and contained in a different plane than the first set, and wherein second wire-elements are arranged obliquely to said first wire-like elements and the second set of second wire-like elements forms an angle of between 0.1 and 89.9 degrees with the first set of first wire-like elements.

The spatial or geometrical pattern of the wire-like element in the scaffold is not limited to the described pattern herein and may include more complex pattern as a combination of a 2D framework and a 3D framework or the presence of more than one set of wire-like elements in the same plane as the first set of first wire-like elements or as the second set of second wire-like elements, said wire-like element of the more than one set of wire-like elements are parallel the ones to the other but are not parallel to the first set or to the second set, respectively.

In the scaffold, the spatial arrangement of the wire-like elements can be determined by the use of the composite, and even by the architecture of the device comprising such a composite. It is therefore necessary to limit as little as possible the possibilities for the design or geometric pattern of the wire-like elements and the choice of materials for these elements.

As known in the art, the crystallogenesis of metal halide perovskite material to produce a perovskite single crystal includes solution processes such as solution temperature lowering method (STL) or inverse temperature crystallization method (ITC). All these methods need the presence of a seed to start the crystallogenesis of the single crystal in the supersaturated metal halide perovskite solution. The seed may be a metal halide perovskite crystallite, a metal halide perovskite single crystal or even a composite of the invention.

In the crystallogenetic process, the orientation of the seed crystal, that is, the orientation of a selected external facet of the same, determines the directions of the crystal planes of the single crystal in growing progress. Thus, a proper orientation of the seed versus the wire-like elements permits to obtain a desired orientation of a crystal plane of the final perovskite single crystal versus specific wire-like elements. A crystallogenetic process and a crystallite or a seed crystal 6 in growing progress are shown in Figure 2.

According to an embodiment, the scaffold in the composite is a framework of wire-like elements comprises at least one set of wire-like elements being arranged in parallel with respect to an external facet of the metal halide perovskite single crystal.

According to another embodiment, the scaffold in the composite is a framework of wire-like elements comprises at least one set of wire-like elements being arranged perpendicularly with respect to an external facet of the metal halide perovskite single crystal.

According to another embodiment, the scaffold in the composite is a framework of wire-like elements comprising at least one set of wire-like elements being arranged obliquely at an angle of between 0.1 and 89.9 degrees with respect to an external facet of the metal halide perovskite single crystal.

According to a further embodiment, the scaffold in the composite is a framework comprising furthermore a set of wire-like elements, wherein the wire-like elements are not parallel to the wire-like elements of the at least one set.

According to one embodiment, the scaffold is produced by ink-jet printing and/or by 3D printing, moulding, full casting, machining (e.g. milling, turning, carving), extrusion, sintering, spinning, lithography and etching the wire-like elements in an arrangement such as an array or a network with simple or complex geometric shape and architecture. These methods of manufacturing the scaffold offer great flexibility in designing complex geometric pattern of the elements. They also allow the use of various materials for producing said elements, such as metals, noble metals, non-conductive or conductive materials, and inert or inactive materials. Said elements may be further electroplated to avoid interfacial damaging recombination or reactions.

In several embodiments, the scaffold is produced by using a holding means. The holder is a frame comprising at least two sides and an inner space, wherein the wire-like elements are arranged in an oriented manner. The wire-like elements are arranged across and/or on one or more sides of the holder or frame. Each side of the holder comprises a plurality of retaining or holding means enabling the wire-like elements to be arranged in a given orientation and to be fitted together in a 2D or 3D pattern. The retaining or holding means in the side of the frame are selected from holes, gutters, hangers or hooks.

The holder or frame is a tool used in the fabrication process, not a support or substrate as disclosed in the prior art, on which the composite is fabricated and on which it rests. Said holder or frame is not included or embedded in the matrix of metal halide perovskite single crystal. It does not belong to the composite or form part of the composite. Said holder or frame helps to maintain the spatial configuration of the crossed and/or oriented wire-like elements in a horizontal, vertical and/or inclined plan during the crystallogenesis of the perovskite single crystal. The holder or frame, as mentioned above, may also allow the manipulation of the scaffold, the wire-like elements and thus the composite during its manufacture.

In a further embodiment, independently of the mode of the fabrication, the as-prepared scaffold can be self-supporting or not. Said as-prepared scaffold may comprise self-supporting wire-like elements. In the case of a non-self-supporting scaffold, the wire-like elements are maintained in place or as-arranged thanks to a holder or a frame as defined-above or to a support which is not included in the matrix of metal halide perovskite single crystal.

In various embodiments, the scaffold is either localized in the bulk of the matrix, in the middle of the matrix of metal halide perovskite single crystal, or juxtaposed near to a side or a surface of said composite, or located at a side or surface of said composite. A holder or a frame as defined above can be used to maintain the scaffold being or not self-supporting during the step of the crystallization of the metal halide perovskite. Thanks to the holder, the scaffold can be disposed anywhere in the reaction vessel and not only at the bottom of the reaction vessel and in any given position. Thus, the crystallization of the perovskite single crystal can be controlled and carried out in a localised way, involving only one or more segments of the scaffold.

According to an embodiment, the plurality of wire-like elements of the composite and/or the scaffold is embedded in the matrix of metal halide perovskite single crystal.

According to a further embodiment, the plurality of wire-like elements of the composite and/or the scaffold is totally embedded in the matrix of metal halide perovskite single crystal.

According to another embodiment, one or more segments of the scaffold are unembedded in the matrix. The one or more unembedded segments are free of the metal halide perovskite single crystal and are accessible to one or more connections or contact means. Preferably, the at least one segment of the wire-like elements being free of the matrix comprises or is at least one end of the wire-like elements. Said free matrix segment protrudes from the matrix of the composite as shown in Figures 3, 4.1 and 4.2.

The partial embedding of the scaffold or the wire-like elements can be provided by submitting one or more segments of the scaffold or of the plurality of the elements to a localized crystallogenesis of the perovskite single crystal matrix and/or by machining operation such as precision milling, laser drilling, polishing, cutting and/or etching to remove the perovskite single crystal matrix around said elements after the crystallization step. These methods for removing part of the matrix can be also used for cutting and/or tailoring the matrix and, therefore, the composite after its manufacturing or crystal post-growth.

During the crystal post-growth shaping or tailoring of the matrix, the scaffold of the wire-like elements plays the role of fibre reinforcement. It improves the impact resistance during polishing, and/or cutting. It reduces the tendency of micro-cracks formation, and crack widths.

Said one or more segments of the scaffold or of the wire-like elements, in particular the one end of said elements, which are free of matrix, may be accessible to one or more connections or contact means, such as, for example, electrical contacts, optical contacts, contact means for temperature control or heat management, or contact means for managing the integrity state of the composite. For example, these segments free of the perovskite matrix may be area for providing contacts with means to avoid crack or fracture formation during the crystallization of the perovskite crystal, the tailoring of said single crystal or composite, or even during the functioning of a device comprising a composite. Wire-like elements can well dissipate the heat induced by the machining of the perovskite crystal or by the crystallization of the perovskite, in particular, if the wire-like elements are made of heat conductive material. Furthermore, if the wire-like elements are made of electric conductor material, the heat-induced mechanical and chemical damages can be reduced by controlling the heat via Joule effect and Peltier effect trough heat spreading or heat transfers and distribution in the bulk of the composite or the device. Such active or passive heat management may improve the operational stability and the lifetime of devices comprising such composite and the composite per se.

According to another embodiment, the wire-like elements are independently selected from wires, fibres, tubes, fibre electrodes, or a combination thereof. According to the present invention, the wire-like elements are elements that can be manipulated and maintained in a determined orientation to form a scaffold in the holder developed by the inventors.

In an embodiment, a unity of wire-like elements has a diameter being in the range from 6 to 5000 µm, preferably from 20 to 1000 µm.

In several embodiments, the wire-like elements have to be disposed in a determined orientation through the use of the holder shaped as a frame described herein and thus, they are subject to manipulations to arrange them in said holder to form a scaffold. Thus, two groups of wire-like elements based on the diameter of the wire-like element can be distinguished.

In an embodiment, a unity of wire-like elements has a diameter being in the range from 6 to about 150 µm, more preferably from 10 to 149 µm. The scaffold comprising these wire-like elements is provided with a method, which does not involve the use of a holder as described herein.

In an embodiment, a unity of wire-like elements has a diameter being over 150 µm being in the range from about 150 to 5·10³ µm. The size of these wire-like elements is suitable for their manipulation and their arrangement in the holder to provide a scaffold with wire-like elements oriented in a determined manner.

According to another embodiment, the length-width ratio of a unity of the wire-like element is in the range from 2 to 10⁶, preferably 5 to 10⁴.

According to an embodiment, the wire-like elements in the scaffold are spaced from one to the other from 6 to 10⁴ µm, preferable 100 to 5000 µm.

The concentration of wire-like elements in the perovskite single crystal, i.e. the ratio between the total volume or cumulative volume of all the wire-like elements embedded in the matrix and the volume of the perovskite matrix in percentage, is in the range from 10⁻⁶ to 8·10⁻¹ vol.%, preferably from 10⁻⁵ to 6·10⁻¹ vol.%.

According to another embodiment, these elements are isolated and/or interconnected. The interconnection between the elements may contribute to the self-supporting property of the scaffold. The selection of wire-like elements being interconnected or isolated depends on the type of the target device and its functioning. For example, for neural implants, image sensors, supercapacitors, batteries and solar cells, wire-like elements being isolated or not interconnected may be preferred.

In a further embodiment, the wire-like elements are hollow or solid elements or a combination thereof, which comprise one or more materials selected from conductive material, non-conductive material, p-type semiconductor, n-type semiconductor or any combination thereof.

The wire-like elements comprise, consist of or are made from one or more materials being conductive or non-conductive, or a combination thereof. Conductive material is selected from Pt, Au, Pd, Ag, Cu, Ti, Ta, Al, Cd, Zn, Te, Ni, Mn, Fe, metal oxides thereof, stainless steel, polyaniline, carbon, graphite, electrically conductive glass, or any combination thereof, preferably Pt, Au, Ga, In, polyaniline, carbon, or any combination thereof. Non-conductive material or insulator material is selected from Teflon^{™}, quartz, glass, alumina, sapphire, zirconia, titania, diamond, PEEK (Polyether ether ketone), or any combination thereof, preferably gass, Teflon^{™}, alumina, or any combination thereof. Non-conductive material is used to electrically and/or thermally isolate the wire-like elements from the metal halide perovskite and/or to fabricate the wire-like elements.

Further materials for producing the wire-like elements, and thus the scaffold may be selected from organic and/or inorganic p-type semiconductor or n-type semiconductor. Such semiconductor may be in electric contact with the metal halide perovskite.

The material of p-type semiconductor material may be selected from semiconductor particles comprising NiO, CuO, CuSCN, CuI, CuGaO₂, CuCrO₂ or CuAlO₂ or any combination thereof or from triphenylamine, carbazole, N,N,(diphenyl)-N',N'di-(alkylphenyl)-4,4'-biphenyldiamine, (pTPDs), diphenylhydrazone, poly [N,N'-bis(4-butylphenyl)-N,N'-bis(phenyl)benzidine] (polyTPD), polyTPD substituted by electron donor groups and/or acceptor groups, poly(9,9-dioctylfluorene-alt-N-(4-butylphenyl)-diphenylamine (TFB), 2,2',7,7'-tetrakis-N,N-di-p-methoxyphenylamine-9,9'-spirobifluorene (spiro-OMeTAD), N,N,N',N'-tetraphenylbenzidine (TPD), poly[bis(4-phenyl)(2,4,6-trimethylphenyl)amine] (PTAA), or any combination thereof.

The material of the n-type semiconductor may be selected from metal oxide, such as Fe-oxide Mg-oxide, Hf-oxide, Ga-oxide, In-oxide, Nb-oxide, Ti-oxide, Ta-oxide, Y-oxide, Zn-oxide, Zr-oxide, or any combination thereof, and/or from Si, CdS, ZnS, PbS, Bi₂S₃, CdSe, CdTe, GaP, InP, GaAs, CulnS₂, CulnSe₂, or any combination thereof. Preferably, the metal oxide of the n-type semiconductor is selected from TiO₂, SnO₂, ZnO, Zn₂SnO₄, Nb₂O₅, WO₃, BaTiO₃, Fe₂O₃, SrTiO₃, or any combination thereof.

Further materials may also be used for manufacturing the scaffold and/or the wire-like elements, such as carbon, indium doped tin oxide (ITO), fluorine doped tin oxide (FTO), ZnO-Ga₂O₃, ZnO-AbO₃, tin-oxide, antimony doped tin oxide (ATO), SrGeO₃. Such materials as well as p-type or n-type semiconductor materials, conductive or non-conductive material as defined above may be also selected for producing layer such as conductive support, current collector, hole collector, etc...,which can coat or be applied on the composite after its fabrication and/or its milling or machining. Additional layers coating the composite can also be made from transparent substrate, such as plastic or glass.

The wire-like elements may be hollow elements, solid elements and/or a combination thereof. In the case of hollow elements, the matrix of metal halide perovskite single crystal protrudes in the cavity of said elements. During crystallogenesis, the matrix metal halide perovskite single crystal is able to grow around a structure and into any cavity of the structure, whether it is the wire-like element or the scaffold. Such a property allows the fabrication of an internal scaffold. Based on hollow wire-like elements and/or a scaffold presenting a hollow spatial arrangement, such internal scaffold can be advantageously part of, e.g., means for heat management, or optical sensing/actuating means for detector with a 3D architecture.

In case of heat management of a device comprising a composite with a scaffold of hollow elements or a scaffold with a hollow spatial arrangement, refrigerant/heating liquid or gas can circulate into the internal scaffold to balance the temperature of the perovskite matrix of the composite. Such active heat management improves the performance stability and the lifetime of devices comprising a composite with hollow elements based scaffold.

When the scaffold is made from wire-like elements being hollow and/or transparent to the white light, i.e. made with materials transparent to the white light such as glass, quartz, etc., or, when the scaffold has a hollow spatial arrangement and/or is transparent to the light, a composite comprising such a scaffold may provide optical sensing or actuating means for devices such as 3D optical detector. Thus the local excitation in the perovskite single crystal is detected through the measurement of the photons emission (photoluminescence).

In a further embodiment, the metal halide perovskite single crystal of the matrix comprises a material selected from a metal halide perovskite or a metal halide perovskite derivative of any one of formulae:

AMX₃ (I)

AA'N_{2/3}X₄ (II)

AN_{2/3}X₃ (III)

AA'MX₄ (IV)

BMX₄ (V)

BN_{2/3}X₄ (VI)

wherein,
- A and A' are monovalent cations being independently selected from NH₄⁺, CH₃NH₃⁺, CH₃CH₂NH₃⁺, CH(NH₂)₂⁺, CH₃C(NH₂)₂⁺, C((NH)₂)₃⁺, (CH₃)₄N⁺, (CH₃)₂NH₂⁺, (CH₃)₃NH⁺, Li⁺, Na⁺, Cs⁺, Rb⁺, K⁺, Ag⁺, Cu⁺, or a combination thereof;
- B is a bivalent cation selected from a group consisting of cation Mg²⁺, Ca²⁺, Sr²⁺, Ba²⁺, Sn2+, Ti²⁺, V²⁺, Ni²⁺, Cr²⁺, Co²⁺, Fe²⁺, Cu²⁺, Zn²⁺, Mn²⁺, NH₃CH₂CH₂NH₃²⁺, NH₃(CH₂)₆NH₃²⁺, NH₃(CH₂)₈NH₃²⁺, and NH₃C₆H₄NH₃²⁺, or a combination thereof;
- M is selected from Pb²⁺, Sn²⁺, Cu²⁺, Ni²⁺, Co²⁺, Fe²⁺, Mn²⁺, Cr²⁺, Pd²⁺, Cd²⁺, Ge²⁺, Eu²⁺, Yb²⁺, or an alloy thereof;
- N is selected from Bi³⁺, Sb³⁺ and In³⁺;
- X are independently selected from Br⁻, I⁻, Cl⁻, SCN⁻, CN⁻, NC⁻, OCN⁻, NCO⁻, NCS⁻, SeCN⁻, TeCN⁻, PF₆⁻, BF₄⁻, or a combination thereof.

In a further aspect, the invention also relates to a perovskite-based device comprising a composite as described above. The present perovskite-based device is selected from an optoelectronic device, a photoelectrochemical device, or a two- or three-dimensional electrodes array. The present optoelectronic device is selected from a photovoltaic device, a solar cell, a phototransistor, a photodetector, a light-emitting electrochemical cell, a LED (light-emitting diode), a solid-state radiation detector, a sensor selected from gas, a liquid or optical sensor, a fuel cell, a memristor, a magneto-optical data storage device, and a thermoelectric device.

In another aspect, the composite according to invention is used for improving the mechanical and/or thermal resistances of a perovskite-based device. In particular, the temperature of the perovskite-based device is controlled and managed through the composite.

The present invention will now be illustrated by way of examples. These examples do not limit the scope of this invention, which is defined by the appended claims.

Although the present invention has been explained in relation to its preferred embodiment, it is to be understood that many other modifications and variations can be made without departing from the scope of the invention as hereinafter claimed.

### Examples

### Example 1: carbon-electrode array

Graphite cylinders with a diameter of 500 microns have been parallelly aligned with a 3 mm spacing and placed to a saturated solution of MAPbBr₃ in DMF. A small MAPbBr₃ single crystal (10 mm³) was used as a seed crystal and was placed atop of the device holding the graphite rods. The inverse temperature crystallization (ITC method) was initialized by steadily increasing the temperature (0.15 °C per hour). During the crystal growth, the matrix of perovskite single crystal was touching the graphite rods and the internal volume of the single crystal gradually protruded such that the graphite rods were engulfed by the matrix. This resulted in a 3-dimensionally enlarged photosensitive interface (Figures 3, 4.1 and 4.2).

The carbon cylinders have at least one wire end not covered by the crystal-wire composite. The surface containing the carbon cylinders have been polished. (Figures 4.3 and 4.4). Polish ability of the carbon cylinder-halide perovskite composite single crystal without delamination and crack formation near the cylinders show the intimate beneficial fiber-matrix stress-strain characteristics.

### Example 2: liquid-cooled MAPbB₃ single-crystal

Perovskite single crystal having grown around inorganic material, polymer or inert metal tubing can be used as active cooling or heating systems by circulating a cooling/heating agent in the tubing system. The cooling agent can be various circulated fluids, gas or liquid.

This cooling network can be evenly cooled/heated the composite to avoid the appearance of local overheated portions in the core of the crystals. This tubing system can be used for temperature measurements to improve the performance of a device or a detector. Further the cooling network can prevent the thermal dilatation of the perovskite single crystal.

Both ends closed glass capillary tubes with a diameter of 600 microns have been parallelly aligned with a 3 mm spacing and placed to a saturated solution of MAPbBr₃ in DMF. A small MAPbBr₃ single crystal (10 mm³) was used as a single crystal and was placed on the middle of two capillaries in the first (bottom) row of the arranged glass capillaries. The inverse temperature crystallization was initialized by steadily increasing the temperature (0.15 °C/h). During the crystal growth, the facets were touching the glass tubes and the internal volume of the crystal gradually protruded such that the glass capillaries were engulfed by the internal crystal atoms. This resulted in a single crystal that contained parallel capillaries (Figure 5). Both ends of the capillaries were out from the bulk crystal. When the preferred size was reached, the crystal with the capillaries was removed from the solution and cleaned from the solution. Both ends of the capillaries were opened and connected to a cooling system with the cooling fluid circulating in it.

## Claims

1. A composite comprising a matrix of metal halide perovskite single crystal and a scaffold comprising a plurality of wire-like elements having a diameter being in the range from 6 to 5000 µm.

2. The composite of claim 1, **characterized in that** the wire-like elements have a diameter being in the range from 6 to about 150 µm.

3. The composite of claim 1, **characterized in that** the wire-like elements have a diameter being in the range from about 150 to 5000 µm.

4. The composite according to any one of the preceding claims, **characterized in that** the matrix of metal halide perovskite single crystal comprises one metal halide perovskite single crystal.

5. The composite according to any one of the preceding claims, **characterized in that** one or more segments of the scaffold are unembedded in the matrix of metal halide perovskite single crystal.

6. The composite according to claim 5, **characterized in that** said at least one segment of the wire-like structure being free of the matrix is at least one end of the wire-like elements.

7. The composite according to any one of the preceding claims, **characterized in that** the scaffold is a two-dimensional framework of wire-like elements.

8. The composite according to claim 7, **characterized in that** the two-dimensional framework comprises a first set of first wire-like elements, wherein said first wire-like elements are parallel the ones to the others and contained in a same plane.

9. The composite according to claim 8, **characterized in that** the two-dimensional framework comprises furthermore a second set of second wire-like elements, wherein said second wire-like elements are parallel the ones to the others and contained in the same plane or substantially in the same plane as the first set, and wherein said second wire-elements are not parallel to said first wire--like elements.

10. The composite according to any one of claims 1 to 6, **characterized in that** the scaffold is a three-dimensional framework of wire-like elements.

11. The composite according to claim 10, **characterized in that** the three-dimensional framework comprises a first set of first wire-like elements, wherein said first wire-like elements are parallel the ones to the others and are contained in a same plane or substantially in a same plane, and a second set of second wire-like elements, wherein said second wire-like elements are parallel the ones to the others and contained in a different plane than the first set, and wherein second wire-elements are not parallel to said first wire-like elements.

12. The composite according to any one of the preceding claims, **characterized in that** the wire-like elements are hollow or solid elements or a combination thereof, which comprise one or more materials selected from conductive material, non-conductive material, p-type semiconductor, n-type semiconductor or any combination thereof.

13. The composite according to any one of the preceding claims, **characterized in that** the metal halide perovskite single crystal comprises a material selected from a metal halide perovskite or a metal halide perovskite derivative of any one of formulae (I) to (VI):
AMX₃ (I)
AA'N_{2/3}X₄ (II)
AN_{2/3}X₃ (III)
AA'MX₄ (IV)
BMX₄ (V)
BN_{2/3}X₄ (VI)
wherein,
- A and A' are monovalent cations being independently selected from NH₄⁺, CH₃NH₃⁺, CH₃CH₂NH₃⁺, CH(NH₂)₂⁺, CH₃C(NH₂)₂⁺, C((NH)₂)₃⁺, (CH₃)₄N⁺, (CH₃)₂NH₂⁺, (CH₃)₃NH⁺, Li⁺, Na⁺, Cs⁺, Rb⁺, K⁺, Ag⁺, Cu⁺, or a combination thereof;
- B is a bivalent cation selected from a group consisting of cation Mg²⁺, Ca²⁺, Sr²⁺, Ba²⁺, Sn2+, Ti²⁺, V²⁺, Ni²⁺, Cr²⁺, Co²⁺, Fe²⁺, Cu²⁺, Zn²⁺, Mn²⁺, NH₃CH₂CH₂NH₃²⁺, NH₃(CH₂)₆NH₃²⁺, NH₃(CH₂)₈NH₃²⁺, and NH₃C₆H₄NH₃²⁺, or a combination thereof;
- M is selected from Pb²⁺, Sn²⁺, Cu²⁺, Ni²⁺, Co²⁺, Fe²⁺, Mn²⁺, Cr²⁺, Pd²⁺, Cd²⁺, Ge²⁺, Eu²⁺, Yb²⁺, or an alloy thereof;
- N is selected from Bi³⁺, Sb³⁺ and In³⁺;
- X are independently selected from Br⁻, I⁻, Cl⁻, SCN⁻, CN⁻, NC⁻, OCN⁻, NCO⁻, NCS⁻, SeCN⁻, TeCN⁻, PF₆⁻, BF₄⁻, or a combination thereof.

14. A perovskite-based device comprising a composite according to any one of claim 1-13 and being selected from an optoelectronic device, a photoelectrochemical device, or a two- or three-dimensional electrodes array.

15. Use of a composite according to claim to any one of claims 1-13 for improving the mechanical and/or thermal resistances of a perovskite-based device.
